# EUROPEAN PATENT APPLICATION

(11) **EP 3 438 983 A1**
(43) Date of publication of application: **06.02.2019**
(21) Application number: 18181284.3
(22) Date of filing: 02.07.2018
(51) Int. Cl.: G11C 8/12, G11C 16/08, G06F 12/02, G06F 12/06

(54) **SEMICONDUCTOR MEMORY DEVICE AND CONTROL METHOD THEREFOR**

(30) Priority: 02.08.2017 JP 2017149844
(71) Applicant: Renesas Electronics Corporation, Tokyo 135-0061 (JP)
(72) Inventor: SAWADA, Seiji, Tokyo, Tokyo 135-0061 (JP)
(74) Representative: Mewburn Ellis LLP

(57) **Abstract**

To prolong the lifetime of a semiconductor memory device, preferably a flash memory device, without performing complicated control. A semiconductor memory device according to one embodiment is equipped with a bank A and a bank B operable complementarily to each other, and a bank selection circuit (14) which selects either one of the banks A (11) and B (12). The bank selection circuit alternately switches the bank to be selected, each time an erase command to instruct erasing of data in either one of the banks A and B is issued. A flag area (13) stores a flag indicative as to which bank is active. When one bank is active, its complementary bank is not active. The memory may further comprise a mode switching circuit which switches an operation mode between a first mode of selecting either one of the first and second banks by using the bank selection circuit and enabling data to be stored in either one of the first and second banks, and a second mode of accessing both the first and second banks by using different addresses respectively and enabling data to be stored therein.

## Description

### CROSS-REFERENCE TO RELATED APPLICATIONS

The disclosure of Japanese Patent Application No. 2017-149844 filed on August 2, 2017 including the specification, drawings and abstract is incorporated herein by reference in its entirety.

### BACKGROUND

The present invention relates to a semiconductor memory device and a control method for the semiconductor memory device, and to, for example, a nonvolatile semiconductor memory device and a control method for a semiconductor memory device.

Since a nonvolatile semiconductor memory device has an advantage that data is not erased even when the supply of power is stopped, but is deteriorated in terms of a memory cell by repetition of a write operation and an erase operation, there is a limit to the number of times of rewriting.

There has been disclosed in Patent Document 1, a technique for prolonging the lifetime of a nonvolatile semiconductor memory device. In the technique disclosed in Patent Document 1, a main memory area and a spare memory area are provided within a memory mat. When the number of times of rewriting of data for each memory cell within a main memory area reaches a limit, the rewriting of data for each memory cell in the spare memory area is performed in place of the memory cell in the main memory area to thereby prolong the lifetime of the semiconductor memory device.

### [Related Art Documents]

### [Patent Document]

[Patent Document 1] Japanese Unexamined Patent Publication Laid-Open No. 2002-208287

### SUMMARY

As described above, the technique disclosed in Patent Document 1 performs the rewriting of the data for the memory cell in the spare memory area in place of the memory cell in the main memory area when the number of times of rewriting of the data for the memory cell in the main memory area has reached the limit, thereby prolonging the lifetime of the semiconductor memory device.

However, as in the technique disclosed in Patent Document 1, the processing of counting the number of times of rewriting of data and switching the memory cell to be rewritten according to its counted value has a problem in that control of the semiconductor memory device becomes complicated.

Other objects and novel features of the present invention will become apparent from the description of the present specification and the accompanying drawings.

According to one aspect of the present invention, there is provided a semiconductor memory device equipped with first and second banks operable complementarily to each other, which alternately switches the bank to be selected, each time an erase command to instruct erasing of data in either one of the first and second banks is issued.

According to the one aspect of the present invention, it is possible to prolong the lifetime of a semiconductor memory device without performing complicated control.

### BRIEF DESCRIPTION OF THE DRAWINGS

FIG. 1 is a block diagram showing a configuration example of a semiconductor memory device according to an embodiment 1;
FIG. 2 is a flowchart illustrating a read/write operation of the semiconductor memory device according to the embodiment 1;
FIG. 3 is a flowchart depicting an erase operation of the semiconductor memory device according to the embodiment 1;
FIG. 4 is a diagram for describing a bank switching operation of the semiconductor memory device according to the embodiment 1;
FIG. 5 is a block diagram showing a configuration example of a semiconductor memory device according to a related art;
FIG. 6 is a circuit diagram illustrating a specific configuration example of a bank selection circuit provided in the semiconductor memory device according to the embodiment 1;
FIG. 7 is a circuit diagram showing a specific configuration example of a flag rewriting circuit provided in the semiconductor memory device according to the embodiment 1;
FIG. 8 is a timing chart at the time of a read operation of the semiconductor memory device according to the embodiment 1;
FIG. 9 is a timing chart at the time of a write operation of the semiconductor memory device according to the embodiment 1;
FIG. 10 is a timing chart at the time of an erase operation of the semiconductor memory device according to the embodiment 1;
FIG. 11 is a timing chart at the time of an erase operation of the semiconductor memory device according to the embodiment 1;
FIG. 12 is a block diagram illustrating a configuration example of a semiconductor memory device according to an embodiment 2;
FIG. 13 is a timing chart for describing the operation of a flag rewriting circuit of the semiconductor memory device according to the embodiment 2;
FIG. 14 is a flowchart for describing the operation of the semiconductor memory device according to the embodiment 2;
FIG. 15 is a circuit diagram illustrating a specific configuration example of a bank selection circuit provided in the semiconductor memory device according to the embodiment 2; and
FIG. 16 is a timing chart for describing the operation of the bank selection circuit of the semiconductor memory device according to the embodiment 2.

### DETAILED DESCRIPTION

Preferred embodiments will hereinafter be described with reference to the accompanying drawings.

### <Embodiment 1>

An embodiment 1 will be described below with reference to the accompanying drawings.

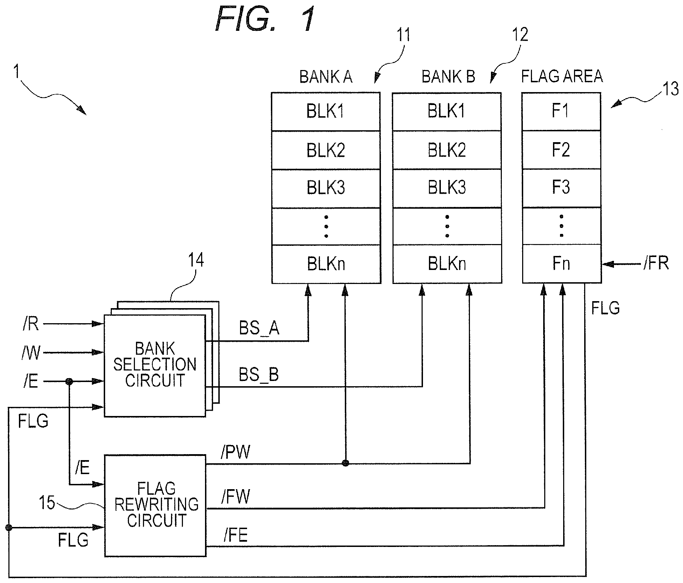

FIG. 1 is a block diagram illustrating a configuration example of a semiconductor memory device according to the embodiment 1. As illustrated in FIG. 1, the semiconductor memory device 1 is equipped with a bank A (11), a bank B (12), a flag area 13, a bank selection circuit 14, and a flag rewriting circuit 15. Incidentally, the bank A (11) and the bank B (12) may hereinafter be described as a bank A and a bank B respectively.

The bank A (11) and the bank B (12) are areas which store data therein and are configured to be operable complementarily to each other. Here, the term "operable complementarily to each other" means that when one bank A (11) is in operation, the other bank B (12) becomes an inactive state, and when one bank A (11) is in an inactive state in reverse, the other bank B (12) becomes in an operating state. In other words, the bank A (11) and the bank B (12) are configured such that they are alternately switched in state, and either the bank A (11) or B (12) becomes operable.

Here, the semiconductor memory device 1 according to the present embodiment is a nonvolatile semiconductor memory device, e.g., a flash memory. The nonvolatile semiconductor memory device has an advantage that data does not disappear even if the supply of power thereto is stopped, but is limited in the number of times of rewriting because a memory cell is deteriorated due to the repetition of a write operation and an erase operation. Considering this point, in the semiconductor memory device 1 according to the present embodiment, the two banks A (11) and B (12) are provided and alternately operated. Thus, the number of times of rewriting in the semiconductor memory device 1 as its whole can be substantially doubled, and hence the lifetime of the semiconductor memory device 1 can be prolonged.

The bank A (11) and the bank B (12) are respectively equipped with block areas BLK1 to BLKn each corresponding to an erase unit of data. Here, n is a natural number of 1 or more. That is, the bank A (11) and the bank B (12) may respectively be equipped with a single block area BLK1 or may be equipped with a plurality of block areas BLK1 through BLKn. The block areas BLK1 through BLKn included in the bank A (11), and the block areas BLK1 through BLKn included in the bank B (12) are provided so as to correspond to each other. Incidentally, a description will hereinafter be made about, as one example, a case in which the bank A (11) and the bank B (12) are respectively equipped with a plurality of block areas BLK1 through BLKn.

In the configuration example illustrated in FIG. 1, the areas to be operated in the bank A (11) and the bank B (12) can be selected in block area units. When focusing on the block areas BLK1, for example, the block area BLK1 in the bank A (11) and the block area BLK1 in the bank B (12) are alternately operated in the semiconductor memory device 1 according to the present embodiment.

Each of the block areas BLK1 through BLKn in the bank A (11) is comprised of a plurality of memory cells (not shown) . Likewise, each of the block areas BLK1 through BLKn in the bank B (12) is comprised of a plurality of memory cells (not shown) . Further, each memory cell in the bank A (11) and each memory cell in the bank B (12) are configured so as to correspond to each other. Thus, when accessing the bank A (11) and the bank B (12) from the outside, it is possible to transparently make accessing to each memory cell in the bank A (11) and each memory cell in the bank B (12) by using the same address. That is, when accessing the semiconductor memory device 1 from the outside, the bank A (11) and the bank B (12) in the semiconductor memory device 1 can be recognized as the same bank.

Flag data indicative of the bank selected out of the bank A (11) and the bank B (12) is stored in the flag area 13. Specifically, the flag area 13 is provided with flag areas F1 through Fn (where n is a natural number of 1 or more) so as to correspond to the block areas BLK1 through BLKn in the respective banks A (11) and B (12). Incidentally, in the present specification, the flag area 13 is also described as the flag areas F1 through Fn.

Flag data indicative of the bank selected out of the bank A (11) and the bank B (12) is stored in the respective flag areas F1 through Fn for every block area BLK1 to BLKn. For example, data related to the block area BLK1 in the selected bank, of the block area BLK1 of the bank A (11) and the block area BLK1 of the bank B (12) is stored in the flag area F1.

The bank selection circuit 14 selects the bank to be operated out of the bank A (11) and the bank B (12). Further, in the present embodiment, the bank selection circuit 14 alternately switch the bank to be selected, each time an erase command to instruct erasing of data of the bank A (11) or the bank B (12) is issued.

In the configuration example shown in FIG. 1, the bank to be operated out of the bank A (11) and the bank B (12) is selected in the block area unit. Thus, the bank selection circuit 14 is configured to select either one of the block areas BLK1 through BLKn in the bank A (11) and the block areas BLK1 through BLKn in the bank B (12), which correspond to each other. Further, each time the erase command is issued, the bank selection circuit 14 alternately switches the bank A (11) and the bank B (12) as an access destination for the block areas BLK1 through BLKn to be selected. More specifically, the bank selection circuit 14 select either one of the block areas BLK1 through BLKn in the bank A (11) and the block areas BLK1 through BLKn in the bank B (12) according to the flag data stored in the flag areas F1 through Fn.

For example, the block area BLK1 will be concretely described. The bank selection circuit 14 selects either one of the block area BLK1 in the bank A (11) and the block area BLK1 in the bank B (12) according to the flag data stored in the flag area F1. Further, the bank selection circuit 14 alternately switches the block area BLK1 in the bank A (11) and the block area BLK1 in the bank B (12) as the block area BLK1 to be selected, each time the erase command is issued.

A read command "/R", a write command "/W", an erase command "/E", and flag data "FLG" are supplied to the bank selection circuit 14. When the read command "/R" is supplied, the bank selection circuit 14 outputs bank selection signal BS_A and BS_B according to the flag data "FLG". Here, the bank selection signals BS_A and BS_B are respectively signals for selecting the bank (bank A or bank B) to execute a read operation. For example, when the read operation is performed on the bank A (11), the bank selection circuit 14 outputs a bank selection signal BS_A of an active state to the bank A (11) and outputs a bank selection signal BS_B of an inactive state to the bank B (12). Then, the semiconductor memory device 1 performs a read operation on a memory cell at a prescribed address of the selected bank A (11).

Also, when the write command "/W" is supplied, the bank selection circuit 14 outputs bank selection signals BS_A and BS_B according to the flag data "FLG" . For example, when a write operation is performed on the bank B (12), the bank selection circuit 14 outputs a bank selection signal BS_A of an inactive state to the bank A (11) and outputs a bank selection signal BS_B of an active state to the bank B (12). Then, the semiconductor memory device 1 performs a write operation on a memory cell at a prescribed address of the selected bank B (12) .

Further, when the erase command "/E" is supplied, the bank selection circuit 14 outputs bank selection signals BS_A and BS_B selecting the bank (bank A or bank B) to execute an erase operation according to the flag data "FLG". Then, the semiconductor memory device 1 erases data in a prescribed block area of the selected bank.

For example, the bank selection circuit 14 is logically provided for every block area BLK1 to BLKn. That is, in the configuration example shown in FIG. 1, since n block areas BLK1 through BLKn are provided, n bank selection circuits 14 are logically provided so as to correspond to the respective block areas BLK1 through BLKn.

The flag rewriting circuit 15 rewrites the flag data stored in the flag area 13. Specifically, the flag rewriting circuit 15 alternately rewrites the flag data indicative of the bank A (11) and the flag data indicative of the bank B (12) each time the erase command is issued. In the configuration example shown in FIG. 1, the bank to be operated out of the bank A (11) and the bank B (12) is selected in the block area unit. Thus, the flag rewriting circuit 15 alternately rewrites the flag data indicative of the bank A (11) and the flag data indicative of the bank B (12) for each of the flag areas F1 through Fn each time the erase command is issued.

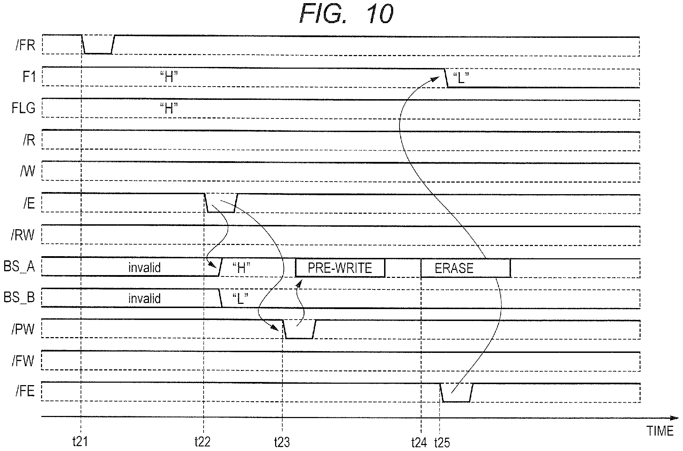

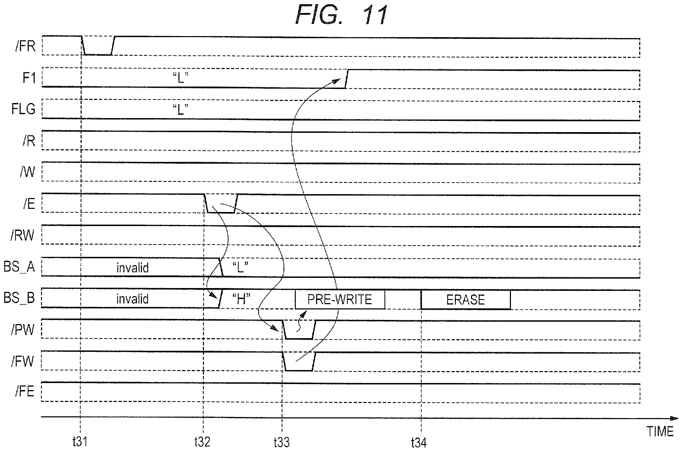

The flag rewriting circuit 15 is supplied with the erase command "/E" and the flag data "FLG". When the erase command "/E" is supplied, the flag rewriting circuit 15 rewrites the flag data of the flag areas F1 through Fn. At this time, the flag rewriting circuit 15 rewrites the flag data of the flag areas F1 through Fn after the operation of bank selection by the bank selection circuit 14 is ended (refer to FIGS. 10 and 11) .

For example, when the flag data of the flag area F1 is at "L (Low level)", the flag rewriting circuit 15 is supplied with low-level flag data "FLG". When the erase command "/E" is supplied in this state, the flag rewriting circuit 15 supplies a flag write signal "/FW" to the flag area F1 to rewrite the flag data of the flag area F1 from "L" to "H (High level)" (i.e., write flag data).

On the other hand, when the flag data of the flag area F1 is at "H", the flag rewriting circuit 15 is supplied with high-level flag data "FLG". When the erase command "/E" is supplied in this state, the flag rewriting circuit 15 supplies a flag erase signal "/FE" to the flag area F1 to rewrite the flag data of the flag area F1 from "H" to "L" (i.e., erase flag data) .

Further, when the erase command "/E" is supplied, the flag rewriting circuit 15 outputs a pre-write signal "/PW" to the bank A (11) and the bank B (12). When the pre-write signal "/PW" is supplied, the bank to be erased of the bank A (11) and the bank B (12) executes pre-writing and thereafter executes an erase operation. The pre-writing is performed to prevent excessive erasure for each memory cell.

The operation of the semiconductor memory device 1 according to the present embodiment will next be described.

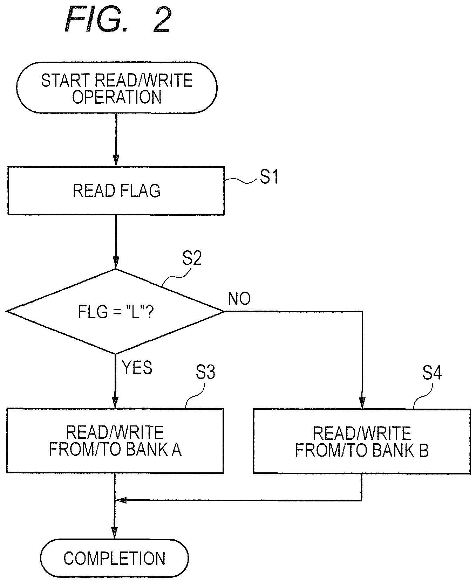

First, the read/write operation of the semiconductor memory device 1 shown in FIG. 1 will be described using a flowchart shown in FIG. 2. Incidentally, the term "read/write" means "read" or "write" in the present specification. That is, the "read" or "write" is described as "read/write" where the "read" or "write" is collectively explained. Further, although the read/write operation of data in the block area BLK1 is described below as one example, the read/write operation of data in each of other block areas BLK2 through BLKn is also similar. Further, in the drawings, "H" means a high level, and "L" means a low level.

When the read/write operation of the semiconductor memory device 1 is executed, the semiconductor memory device 1 first reads flag data stored in the flag area F1 (Step S1). Specifically, the semiconductor memory device 1 shown in FIG. 1 supplies a flag read signal "/FR" of an active state to the flag area F1. When the flag read signal "/FR" of the active state is supplied, the flag area F1 outputs flag data "FLG" ("L" or "H") to the bank selection circuit 14 and the flag rewriting circuit 15. Further, the bank selection circuit 14 is supplied with a read command "/R" and a write command "/W".

When the flag data "FLG" read from the flag area F1 is at the low level (Step S2: Yes), the bank selection circuit 14 outputs a bank selection signal BS_A of an active state to the bank A (11) and a bank selection signal BS_B of an inactive state to the bank B (12) respectively. Thus, the bank A (11) is selected. Thereafter, the semiconductor memory device 1 performs the read/write operation on a memory cell at a prescribed address in the selected bank A (11) (Step S3).

On the other hand, when the flag data "FLG" read from the flag area F1 is at the high level (Step S2: No), the bank selection circuit 14 outputs a bank selection signal BS_A of an inactive state to the bank A (11) and a bank selection signal BS_B of an active state to the bank B (12) respectively. Thus, the bank B (12) is selected. Thereafter, the semiconductor memory device 1 performs the read/write operation on a memory cell at a prescribed address in the selected bank B (12) (Step S4) .

Incidentally, although FIG. 2 has described the case where the bank A (11) is configured to be selected where the flag data "FLG" is at the low level, and the bank B (12) is configured to be selected where the flag data "FLG" is at the high level, the relationship between the flag data "FLG" and the selected bank may be reversed in the present embodiment. That is, the bank A (11) may be configured to be selected where the flag data "FLG" is at the high level, and the bank B (12) may be configured to be selected where the flag data "FLG" is at the low level.

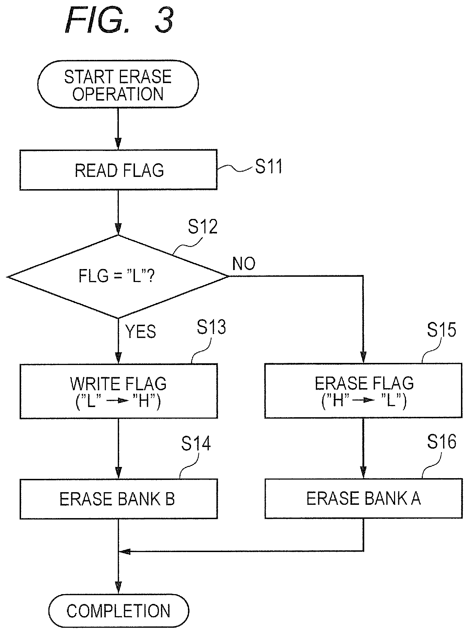

The erase operation of the semiconductor memory device 1 will next be described using a flowchart shown in FIG. 3. Although the erase operation of the block area BLK1 will be described below as one example, the erase operation of each of other block areas BLK2 through BLKn is also similar.

When the erase operation is performed, the semiconductor memory device 1 first reads flag data stored in the flag area F1 (Step S11). Specifically, the semiconductor memory device 1 shown in FIG. 1 supplies a flag read signal "/FR" of an active state to the flag area F1. When the flag read signal "/FR" of the active state is supplied, the flag area F1 outputs flag data "FLG" ("L" or "H") to the bank selection circuit 14 and the flag rewriting circuit 15. Further, the bank selection circuit 14 is supplied with an erase command "/E".

When the flag data "FLG" read from the flag area F1 is at the low level (Step S12: Yes), the flag rewriting circuit 15 supplies a flag write signal "/FW" to the flag area F1 to rewrite the flag data of the flag area F1 from the low level to the high level (Step S13).

When the flag data is at the low level, the bank A (11) is selected upon reading/writing, whereas when the flag data is rewritten to the high level in Step S13, the bank B (12) is selected upon the read/write operation.

Further, the semiconductor memory device 1 according to the present embodiment is configured to erase data of the bank to be next selected. Thus, in this case, the data of the bank B (12) to be next selected is erased. Accordingly, when the erase command "/E" is supplied, the bank selection circuit 14 outputs a bank selection signal BS_A of an inactive state to the bank A (11) and a bank selection signal BS_B of an active state to the bank B (12) respectively to select the bank B (12) . Thus, the data of the block area BLK1 in the bank B (12) is erased (Step S14). Subsequently, the bank B (12) is selected upon the read/write operation.

On the other hand, when the flag data "FLG" read from the flag area F1 is at the high level (Step S12: No), the flag rewriting circuit 15 supplies a flag erase signal "/FE" to the flag area F1 to rewrite the flag data of the flag area F1 from the high level to the low level (in other words, the flag data is erased. Step S15).

Although the bank B (12) is selected upon the read/write operation where the flag data is at the high level, the bank A (11) is selected upon the read/write operation when the flag data is rewritten to the low level in Step S15.

Further, the semiconductor memory device 1 according to the present embodiment is configured to erase data of the bank to be next selected. Thus, in this case, the data of the bank A (11) to be next selected is erased. Accordingly, when the erase command "/E" is supplied, the bank selection circuit 14 outputs a bank selection signal BS_A of an active state to the bank A (11) and a bank selection signal BS_B of an inactive state to the bank B (12) respectively to select the bank A (11). Thus, the data of the block area BLK1 in the bank A (11) is erased (Step S16). Subsequently, the bank A (11) is selected upon the read/write operation.

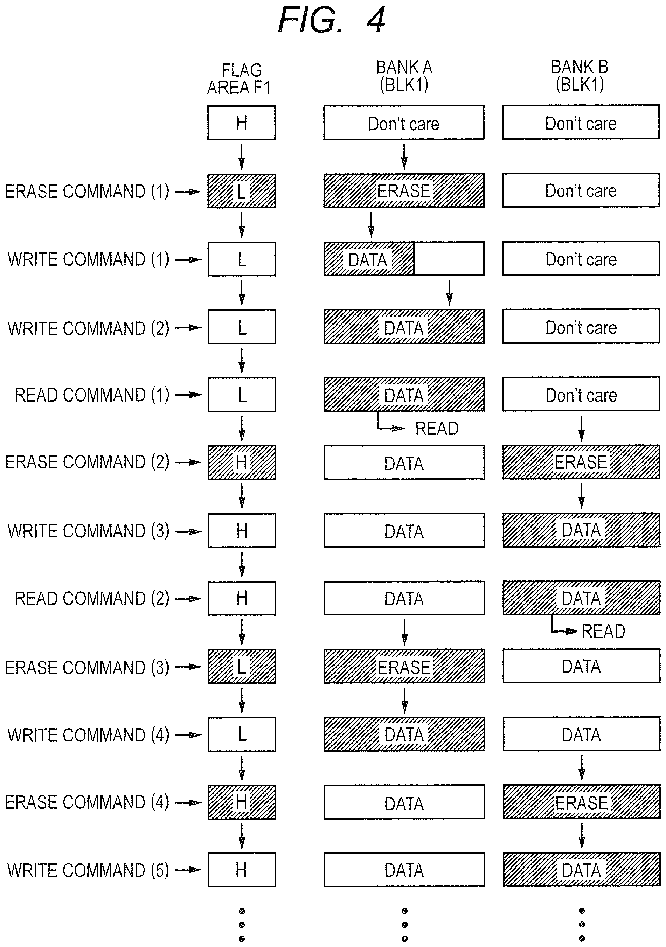

FIG. 4 is a diagram for describing a bank switching operation of the semiconductor memory device according to the present embodiment. In FIG. 4, as an initial state, the flag area F1 is assumed to be "H", and the block area BLK1 of the bank A and the block area BLK1 of the bank B are respectively assumed to be Don't care. Further, in FIG. 4, since the operation where a read/write command is supplied, and the operation where an erase command is supplied are similar to the read/write operation described in FIG. 2 and the erase operation described in FIG. 3, their description will be omitted.

When the erase command (1) is supplied to the bank selection circuit 14 and the bank rewriting circuit 15 in the above-described initial state, the flag area F1 is rewritten from the high level to the low level. Further, the block area BLK1 (i.e., block area in bank where data is next written) in the bank A is erased. Incidentally, each component where a change takes place is shown by hatching in FIG. 4.

Thereafter, when the write command (1) is supplied to the bank selection circuit 14, the bank selection circuit 14 selects the block area BLK1 in the bank A because the flag area F1 is at the low level. Thus, data is written into a prescribed address of the block area BLK1 in the bank A.

Further, when the write command (2) is supplied to the bank selection circuit 14, the bank selection circuit 14 selects the block area BLK1 in the bank A because the flag area F1 is at the low level. Thus, data is written into a prescribed address of the block area BLK1 in the bank A.

Thereafter, when the read command (1) is supplied to the bank selection circuit 14, the bank selection circuit 14 selects the block area BLK1 in the bank A because the flag area F1 is at the low level. Thus, data is written into a prescribed address of the block area BLK1 in the bank A.

Thereafter, when the erase command (2) is supplied to the bank selection circuit 14 and the bank rewriting circuit 15, the flag area F1 is rewritten from the low level to the high level. Further, the block area BLK1 (i.e., block area in bank where data is next written) in the bank B is erased. Incidentally, at this time, the data stored in the block area BLK1 in the bank A is not erased and held until the bank A is next selected (i.e., until the erase command is next supplied) .

Thereafter, when the write command (3) is supplied to the bank selection circuit 14, the bank selection circuit 14 selects the block area BLK1 in the bank B because the flag area F1 is at the high level. Thus, data is written into a prescribed address of the block area BLK1 in the bank B.

Afterwards, when the read command (2) is supplied to the bank selection circuit 14, the bank selection circuit 14 selects the block area BLK1 in the bank B because the flag area F1 is at the high level. Thus, the data stored in the prescribed address of the block area BLK1 in the bank B is read.

Thereafter, when the erase command (3) is supplied to the bank selection circuit 14 and the bank rewriting circuit 15, the flag area F1 is rewritten from the high level to the low level. Further, the block area BLK1 (i.e., block area in bank where data is next written) in the bank A is erased. Incidentally, at this time, the data stored in the block area BLK1 in the bank B is not erased and held until the bank B is next selected (i.e., until the erase command is next supplied) .

Afterwards, when the write command (4) is supplied to the bank selection circuit 14, the bank selection circuit 14 selects the block area BLK1 in the bank A because the flag area F1 is at the low level. Thus, data is written into a prescribed address of the block area BLK1 in the bank A.

Thereafter, when the erase command (4) is supplied to the bank selection circuit 14 and the bank rewriting circuit 15, the flag area F1 is rewritten from the low level to the high level. Further, the block area BLK1 (i.e., block area in bank where data is next written) in the bank B is erased.

After that, when the write command (5) is supplied to the bank selection circuit 14, the bank selection circuit 14 selects the block area BLK1 in the bank B because the flag area F1 is at the high level. Thus, data is written into a prescribed address of the block area BLK1 in the bank B. Subsequently, the bank selection circuit 14 alternately switches the bank to be selected, each time the erase command is issued.

Thus, in the semiconductor memory device 1 according to the present embodiment, the bank selection circuit 14 alternately switches the bank to be selected, each time the erase command is issued. It is therefore possible to prolong the lifetime of the semiconductor memory device 1 without performing complicated control.

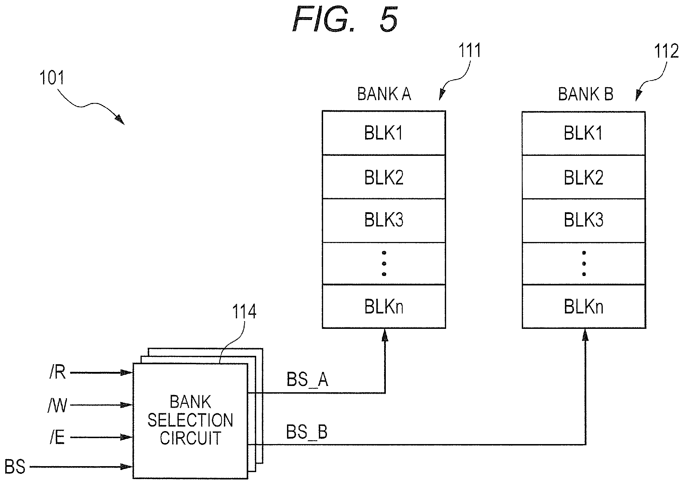

FIG. 5 is a block diagram for describing a semiconductor memory device 101 according to a related art. The semiconductor memory device 101 shown in FIG. 5 is equipped with a bank A (111), a bank B (112), and a bank selection circuit 114. In the semiconductor memory device 101 according to the related art, the lifetime thereof is prolonged by performing data rewriting to each memory cell in the bank B (112) in place of each memory cell in the bank A (111) when, for example, the number of times of rewriting of data for the memory cell of the bank A (111) reaches a limit.

However, as in the semiconductor memory device 101 according to the related art, the processing of counting the number of times of rewriting of data and switching the memory cell to be rewritten according to its counted value involves a problem that the control of the semiconductor memory device becomes complicated. That is, the bank selection circuit 114 switches the bank to be selected according to a bank selection signal BS supplied to the bank selection circuit 114. Here, in the semiconductor memory device 101 according to the related art, the number of times of rewriting of data is counted at an external circuit to generate the bank selection signal BS. When its counted value exceeds a prescribed set value, the bank selection signal BS is supplied from the external circuit to the bank selection circuit 114 to switch the bank to be selected. Therefore, a problem arises in that the control of the semiconductor memory device 101 becomes complicated and its circuit configuration becomes complex.

On the other hand, in the semiconductor memory device 1 according to the present embodiment, each time the erase command is issued, the bank selection circuit 14 automatically alternately switches the bank to be selected. Thus, it is possible to avoid that the control of the semiconductor memory device becomes complicated. Further, since it is not necessary to perform switching of the bank by using the external circuit and provide a complicated circuit in the semiconductor memory device 1 according to the present embodiment, it is possible to simplify the circuit configuration of the semiconductor memory device.

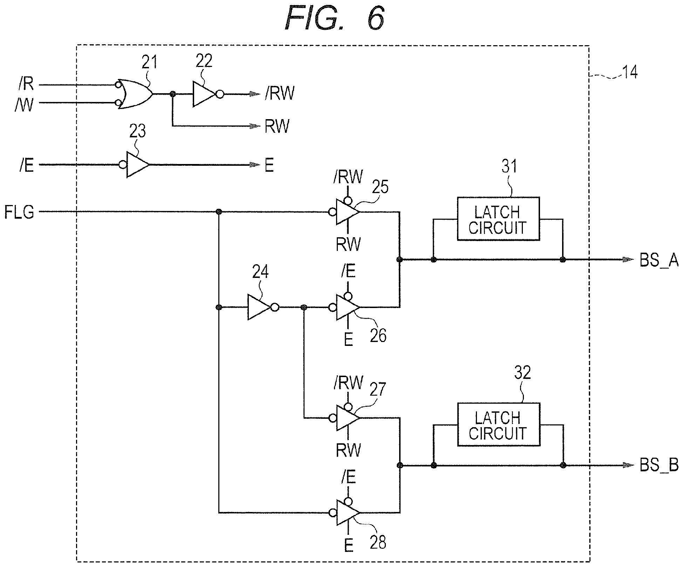

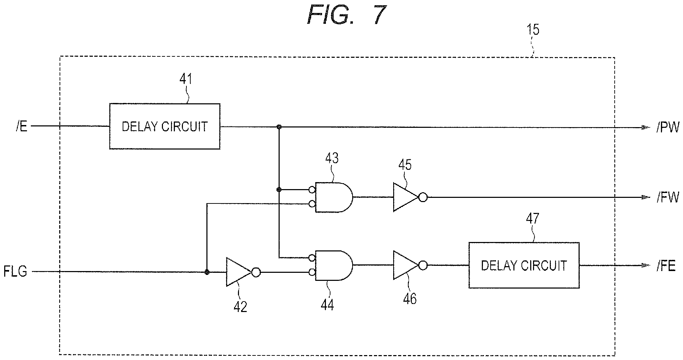

A specific circuit configuration of the semiconductor memory device 1 according to the present embodiment will next be described. FIG. 6 is a circuit diagram illustrating a specific circuit configuration of the bank selection circuit 14 included in the semiconductor memory device 1 according to the present embodiment. FIG. 7 is a circuit diagram illustrating a specific configuration example of the flag rewriting circuit 15 included in the semiconductor memory device 1 according to the present embodiment. Incidentally, the bank selection circuit 14 shown in FIG. 6 and the flag rewriting circuit 15 shown in FIG. 7 are respectively one example. In the present embodiment, any circuit may be used so long as there are provided a bank selection circuit 14 and a flag rewriting circuit 15 both capable of performing the above-described operations.

The bank selection circuit 14 shown in FIG. 6 is equipped with logic circuits 21 through 28 and latch circuits 31 and 32. The logic circuit 21 is an OR circuit equipped with inverse inputs. The logic circuit 21 has one input supplied with a read command "/R", and the other input supplied with a write command "/W". The logic circuit 21 outputs the OR of an inverted signal of the read command "/R" and an inverted signal of the write command "/W" as a signal "RW". The logic circuit 22 is an inverter circuit and outputs a signal "/RW" obtained by inverting the signal "RW" output from the logic circuit 21. The logic circuit 23 is a buffer circuit which is equipped with an inverse input and outputs a signal "E" obtained by inverting the erase command "/E" supplied thereto.

The logic circuit 24 is an inverter circuit and supplies a signal obtained by inverting flag data "FLG" supplied thereto to the logic circuits 26 and 27. The logic circuit 25 is a buffer circuit equipped with an inverse input and outputs, as a bank selection signal BS_A, a signal obtained by inverting the flag data "FLG" according to the signal "/RW" and the signal "RW". The logic circuit 26 is a buffer circuit equipped with an inverse input and outputs, as the bank selection signal BS_A, a signal obtained by inverting the output signal of the logic circuit 24 according to the signal "/E" and the signal "E". The logic circuit 27 is a buffer circuit equipped with an inverse input and outputs, as a bank selection signal BS_B, a signal obtained by inverting the output signal of the logic circuit 24 according to the signal "/RW" and the signal "RW". The logic circuit 28 is a buffer circuit equipped with an inverse input and outputs, as the bank selection signal BS_B, a signal obtained by inverting the flag data "FLG" according to the signal "/E" and the signal "E".

The latch circuit 31 is a circuit which latches the bank selection signal BS_A output from each of the logic circuits 25 and 26. The latch circuit 32 is a circuit which latches the bank selection signal BS_B output from each of the logic circuits 27 and 28.

In the bank selection circuit 14 shown in FIG. 6, when either one of the read command "/R" and the write command "/W" is at a low level (active state), a signal "RW" of a high level (active state) is output from the logic circuit 21. At this time, the logic circuit 22 outputs a signal "/RW" of a low level (active state) . Further, when the erase command "/E" is at the low level (active state), a signal "E" of a high level (active state)is output from the logic circuit 23.

When the signal "/RW" and the signal "RW" are respectively in the active state, the logic circuit 25 outputs, as the bank selection signal BS_A, a signal obtained by inverting the logic level of the flag data "FLG". On the other hand, when the signal "/RW" and the signal "RW" are respectively in the active state, the logic circuit 27 outputs, as the bank selection signal BS_B, a signal obtained by inverting the output of the logic circuit 24.

Specifically described, when the flag data "FLG" is at a low level, the logic circuit 25 outputs a high level signal as the bank selection signal BS_A when the signal "/RW" and the signal "RW" are respectively in an active state. On the other hand, when the signal "/RW" and the signal "RW" are respectively in the active state, the logic circuit 27 outputs a low level signal as the bank selection signal BS_B. Thus, when the flag data "FLG" is at the low level, the bank selection signal BS_A becomes a high level and hence the bank A (11) is selected.

When the flag data "FLG" is at a high level in reverse, the logic circuit 25 outputs a low level signal as the bank selection signal BS_A when the signal "/RW" and the signal "RW" are respectively in the active state. On the other hand, when the signal "/RW" and the signal "RW" are respectively in the active state, the logic circuit 27 outputs a high level signal as the bank selection signal BS_B. Thus, when the flag data "FLG" is at the high level, the bank selection signal BS_B becomes a high level and hence the bank B (12) is selected.

Also, when the erase command "/E" and the signal "E" are respectively in an active state, the logic circuit 26 outputs, as the bank selection signal BS_A, a signal obtained by inverting the output of the logic circuit 24. Further, when the erase command "/E" and the signal "E" are respectively in the active state, the logic circuit 28 outputs, as the bank selection signal BS_B, a signal obtained by inverting the logic level of the flag data "FLG".

Specifically described, when the flag data "FLG" is at a low level, the logic circuit 26 outputs a low level signal as the bank selection signal BS_A when the erase command "/E" and the signal "E" are respectively in an active state. On the other hand, when the erase command "/E" and the signal "E" are respectively in the active state, the logic circuit 28 outputs a high level signal as the bank selection signal BS_B. Thus, in this case, the bank B (12) is selected.

When the flag data "FLG" is at a high level in reverse, the logic circuit 26 outputs a high level signal as the bank selection signal BS_A when the erase command "/E" and the signal "E" are respectively in the active state. On the other hand, when the erase command "/E" and the signal "E" are respectively in the active state, the logic circuit 28 outputs a low level signals as the bank selection signal BS_B. Thus, in this case, the bank A (11) is selected.

That is, when the erase command "/E" and the signal "E" are respectively brought into the active state, the logic levels of the bank selection signals BS_A and BS_B are respectively inverted.

The flag rewriting circuit 15 shown in FIG. 7 will next be described. The flag rewriting circuit 15 shown in FIG. 7 is equipped with delay circuits 41 and 47 and logic circuits 42 through 46. The delay circuit 41 outputs, as a pre-write signal "/PW", a signal obtained by delaying the erase command "/E". The logic circuit 42 is an inverter circuit and outputs a signal obtained by inverting the logic level of the flag data "FLG".

The logic circuit 43 is an AND circuit equipped with an inverse input. The logic circuit 43 has one input supplied with the signal obtained by delaying the erase command "/E" and the other input supplied with the flag data "FLG", and outputs a logical product of inverted signals of these signals. The logic circuit 45 is an inverter circuit and outputs, as a flag write signal "/FW", a signal obtained by inverting the output of the logic circuit 43.

The logic circuit 44 is an AND circuit equipped with an inverse input. The logic circuit 44 has one input supplied with the signal obtained by delaying the erase command "/E" and the other input supplied with the output signal of the logic circuit 42, and outputs a logical product of inverted signals of these signals. The logic circuit 46 is an inverter circuit and outputs a signal obtained by inverting the output of the logic circuit 44 to the delay circuit 47. The delay circuit 47 outputs, as a flag erase signal "/FE", a signal obtained by delaying the output of the logic circuit 46.

In the flag rewriting circuit 15 shown in FIG. 7, the pre-write signal "/PW" becomes in an active state when the erase command "/E" is in an active state.

Further, when the flag data "FLG" is at a low level, the logic circuit 43 outputs a logic signal of a high level when the erase command "/E" becomes in the active level (low level) . The logic signal of the high level output from the logic circuit 43 is inverted by the logic circuit 45 from which a flag write signal "/FW" of a low level (active state) is output. Further, when the flag data "FLG" is at the low level, the logic circuit 44 outputs a logic signal of a low level when the erase command "/E" becomes in the active state (low level) . The logic signal of the low level output from the logic circuit 44 is inverted by the logic circuit 46 from which a flag erase signal "/FE" of a high level (inactive state) is output. Thus, in this case, the flag data "FLG" in the flag area is rewritten from the low level to the high level.

On the other hand, when the flag data "FLG" is at the high level, the logic circuit 43 outputs a logic signal of a low level when the erase command "/E" becomes in the active state (low level) . The logic signal of the low level output from the logic circuit 43 is inverted by the logic circuit 45 from which a flag write signal "/FW" of a high level (inactive state) is output. Further, when the flag data "FLG" is at the high level, the logic circuit 44 outputs a logic signal of a high level when the erase command "/E" becomes in the active state (low level) . The logic signal of the high level output from the logic circuit 44 is inverted by the logic circuit 46 from which a flag erase signal "/FE" of a low level (active state) is output. Thus, in this case, the flag data "FLG" in the flag area is rewritten from the high level to the low level.

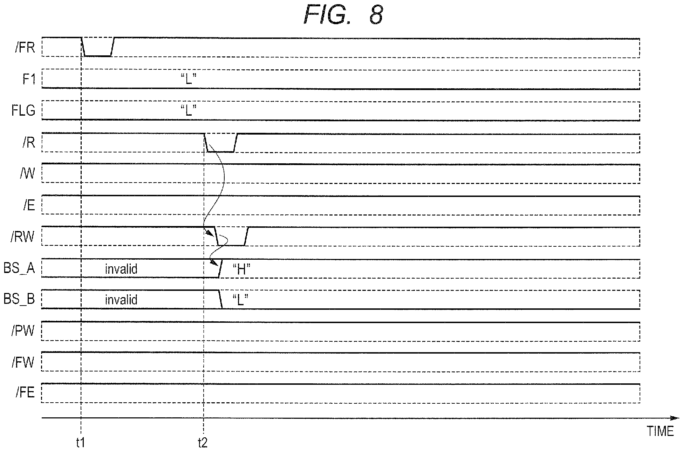

The operation of the semiconductor memory device 1 according to the present embodiment will next be described using timing charts shown in FIGS. 8 through 11. Incidentally, although the operation of the block area BLK1 will be described as one example below, the operations of other block areas BLK2 through BLKn are also similar.

The read operation of the semiconductor memory device 1 according to the present embodiment will first be described using the timing chart shown in FIG. 8. Upon starting the read operation, the flag area F1 (refer to FIG. 1) of the semiconductor memory device 1 is supplied with a flag read signal "/FR" of an active state (low level) at a timing t1. Thus, the flag data stored in the flag area F1 is read. Since the flag data F1 stored in the flag area F1 is at a low level in the case illustrated in FIG. 8, flag data "FLG" of a low level is supplied to the bank selection circuit 14 (refer to FIG. 1) .

Thereafter, when the bank selection circuit 14 is supplied with a read command"/R" of an active state (low level) at a timing t2, a signal "/RW" becomes in an active state (low level) . That is, in the bank selection circuit 14 shown in FIG. 6, the logic circuit 21 outputs a signal "RW" of an active state (high level) when the read command "/R" of the active state is supplied thereto. At this time, the logic circuit 22 outputs a signal "/RW" of an active state (low level).

Further, since the flag data "FLG" is at the low level, the logic circuit 25 outputs a bank selection signal BS_A of a high level when the signal "/RW" and the signal "RW" are respectively brought into the active state. On the other hand, since the flag data "FLG" is at the low level and the output of the logic circuit 24 is high in level, the logic circuit 27 outputs a bank selection signal BS_B of a low level when the signal "/RW" and the signal "RW" are respectively brought into the active state. The bank A (11) is selected by such an operation. Thereafter, the semiconductor memory device 1 performs the read operation on a memory cell at a prescribed address of the selected bank A (11).

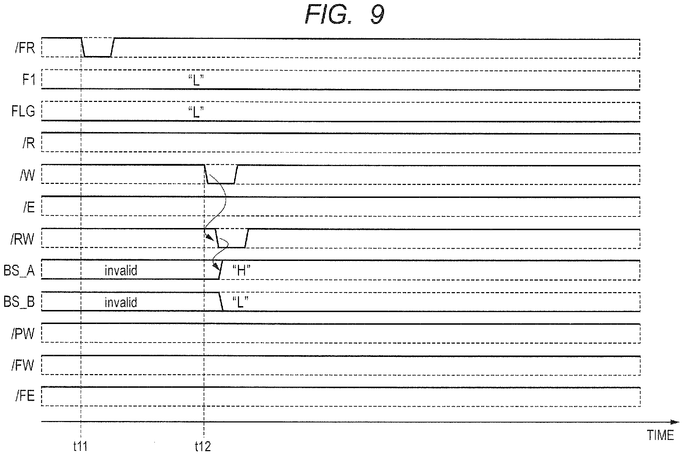

The write operation of the semiconductor memory device 1 according to the present embodiment will next be described using the timing chart shown in FIG. 9. Upon starting the write operation, the flag area F1 (refer to FIG. 1) of the semiconductor memory device 1 is supplied with a flag read signal "/FR" of an active state (low level) at a timing t11. Thus, the flag data stored in the flag area F1 of the semiconductor memory device 1 is read. Since the flag data F1 stored in the flag area F1 is at a low level in the case shown in FIG. 9, flag data "FLG" of a low level is supplied to the bank selection circuit 14 (refer to FIG. 1).

Thereafter, when a write command "/W" of an active state (low level) is supplied to the bank selection circuit 14 at a timing t12, a signal "/RW" becomes in an active state (low level) . That is, in the bank selection circuit 14 shown in FIG. 6, the logic circuit 21 outputs a signal "RW" of an active state (high level) when the write command "/W" of the active state is supplied thereto. At this time, the logic circuit 22 outputs a signal "/RW" of an active state (low level).

Further, since the flag data "FLG" is at the low level, the logic circuit 25 outputs a bank selection signal BS_A of a high level when the signal "/RW" and the signal "RW" are respectively brought into the active state. On the other hand, since the flag data "FLG" is at the low level and the output of the logic circuit 24 is high in level, the logic circuit 27 outputs a bank selection signal BS_B of a low level when the signal "/RW" and the signal "RW" are respectively brought into the active state. The bank A (11) is selected by such an operation. Thereafter, the semiconductor memory device 1 performs the write operation on a memory cell at a prescribed address of the selected bank A (11).

The erase operation of the bank A (11) of the semiconductor memory device 1 according to the present embodiment will next be described using the timing chart shown in FIG. 10. As described in FIG. 4, the timing at which the data of the bank A (11) is erased is a timing at which the flag data stored in the flag area F1 is transitioned from the high level to the low level, in other words, a timing at which the bank to be selected is switched from the bank B (12) to the bank A (11) (refer to, for example, the erase commands (1), (3) and (5) in FIG. 4). Thus, in the timing chart shown in FIG. 10, flag data of a high level is stored in the flag area F1 as an initial value.

Upon starting the erase operation, at a timing t21, a flag read signal "/FR" of an active state (low level) is supplied to the flag area F1 (refer to FIG. 1) of the semiconductor memory device 1. Thus, the flag data stored in the flag area F1 of the semiconductor memory device 1 is read. Since the flag data F1 stored in the flag area F1 is at the high level in the case shown in FIG. 10, flag data "FLG" of a high level is supplied to the bank selection circuit 14 and the flag rewriting circuit 15 (refer to FIG. 1).

Thereafter, when the bank selection circuit 14 and the flag rewriting circuit 15 are supplied with an erase command "/E" of an active state (low level) at a timing t22, the bank selection circuit 14 outputs a bank selection signal BS_A of a high level and a bank selection signal BS_B of a low level respectively.

That is, in the bank selection circuit 14 shown in FIG. 6, the logic circuit 23 outputs a signal "E" of a high level (active state) when the erase command "/E" is brought into the low level (active state) . Further, since the flag data "FLG" is at the high level, the logic circuit 24 outputs a low level signal to the logic circuit 26. Since the output of the logic circuit 24 is at the low level, the logic circuit 26 outputs a bank selection signal BS_A of a high level when the erase command "/E" and the signal "E" are brought into the active state. On the other hand, since the flag data "FLG" is at the high level, the logic circuit 28 outputs a bank selection signal BS_B of a low level when the erase command "/E" and the signal "E" are brought into the active state. By such an operation, the bank A (11) is selected.

Further, after the erase command "/E" is brought into the active state (low level) at the timing t22, the flag rewriting circuit 15 outputs a pre-write signal "/PW" of an active state (low level) at a timing t23. That is, when the erase command "/E" becomes in the active state (low level), the flag rewriting circuit 15 shown in FIG. 7 delays the signal of this active state (low level) by a predetermined time by means of the delay circuit 41 and outputs the delayed signal as the pre-write signal "/PW".

When the pre-write signal "/PW" of the active state is supplied to the bank A (11) (refer to FIG. 1), the bank A (11) performs pre-writing. Thereafter, the bank A (11) executes the erase operation at a timing t24 after the completion of the pre-writing. Consequently, the data stored in the block area BLK1 of the bank A (11) is erased.

Further, since the flag data "FLG" is at the high level when the erase command "/E" is brought into the active state (low level), the logic circuit 43 of the flag rewriting circuit 15 shown in FIG. 7 outputs a logic signal of a low level. The low level logic signal output from the logic circuit 43 is inverted by the logic circuit 45 from which a flag write signal "/FW" of a high level (inactive state) is output. When the erase command "/E" is brought into the active state (low level), the logic circuit 44 outputs a logic signal of a high level because the flag data "FLG" is at the high level. The high level logic signal output from the logic circuit 44 is inverted by the logic circuit 46 from which a flag erase signal "/FE" of a low level (active state) is output. Thus, at a timing t25 shown in FIG. 10, the flag erase signal "/FE" of the low level (active state) is output.

When the flag erase signal "/FE" of the active state is supplied to the flag area F1, the flag data "F1" of the flag area F1 is rewritten from the high level to the low level.

By the above-described operation, the bank to be selected is switched from the bank B (12) to the bank A (11). Further, the data of the block area BLK1 in the bank A (11) is erased.

The erase operation of the bank B (12) of the semiconductor memory device 1 according to the present embodiment will next be described using the timing chart shown in FIG. 11. The timing at which the data of the bank B (12) is erased is a timing at which the flag data stored in the flag area F1 is transitioned from the low level to the high level, in other words, a timing at which the bank to be selected is switched from the bank A (11) to the bank B (12) (refer to, for example, the erase commands (2) and (4) in FIG. 4) . Thus, in the timing chart shown in FIG. 11, flag data of a low level is stored in the flag area F1 as an initial value.

Upon starting the erase operation, at a timing t31, a flag read signal "/FR" of an active state (low level) is supplied to the flag area F1 (refer to FIG. 1) of the semiconductor memory device 1. Thus, the flag data stored in the flag area F1 of the semiconductor memory device 1 is read. Since the flag data F1 stored in the flag area F1 is at the low level in the case shown in FIG. 11, flag data "FLG" of a low level is supplied to the bank selection circuit 14 and the flag rewriting circuit 15 (refer to FIG. 1).

Thereafter, when the bank selection circuit 14 and the flag rewriting circuit 15 are supplied with an erase command "/E" of an active state (low level) at a timing t32, the bank selection circuit 14 outputs a bank selection signal BS_A of a low level and a bank selection signal BS_B of a high level respectively.

That is, in the bank selection circuit 14 shown in FIG. 6, the logic circuit 23 outputs a signal "E" of a high level (active state) when the erase command "/E" is brought into the low level (active state) . Further, since the flag data "FLG" is at the low level, the logic circuit 24 outputs a high level signal to the logic circuit 26. Since the output of the logic circuit 24 is at the high level, the logic circuit 26 outputs a bank selection signal BS_A of a low level when the erase command "/E" and the signal "E" are brought into the active state. On the other hand, since the flag data "FLG" is at the low level, the logic circuit 28 outputs a bank selection signal BS_B of a high level when the erase command "/E" and the signal "E" are brought into the active state. By such an operation, the bank B (12) is selected.

Further, after the erase command "/E" is brought into the active state (low level) at the timing t32, the flag rewriting circuit 15 outputs a pre-write signal "/PW" of an active state (low level) at a timing t33. That is, when the erase command "/E" becomes in the active state (low level), the flag rewriting circuit 15 shown in FIG. 7 delays the signal of this active state (low level) by a predetermined time by means of the delay circuit 41 and outputs the delayed signal as the pre-write signal "/PW".

When the pre-write signal "/PW" of the active state is supplied to the bank B (12) (refer to FIG. 1), the bank B (12) performs pre-writing. Thereafter, the bank B (12) executes the erase operation at a timing t34 after the completion of the pre-writing. Consequently, the data stored in the block area BLK1 of the bank B (12) is erased.

Further, since the flag data "FLG" is at the low level when the erase command "/E" is brought into the active state (low level), the logic circuit 43 of the flag rewriting circuit 15 shown in FIG. 7 outputs a logic signal of a high level. The high level logic signal output from the logic circuit 43 is inverted by the logic circuit 45 from which a flag write signal "/FW" of a low level (active state) is output. On the other hand, since the flag data "FLG" is at the low level and the output of the logic circuit 42 is at the high level when the erase command "/E" is brought into the active state (low level), the logic circuit 44 outputs a logic signal of a low level. The low level logic signal output from the logic circuit 44 is inverted by the logic circuit 46 from which a flag erase signal "/FE" of a high level (inactive state) is output.

That is, since the flag rewriting circuit 15 outputs the flag write signal "/FW" of the active state to the flag area F1 at the timing t33 shown in FIG. 11, the flag data "F1" in the flag area F1 is rewritten from the low level to the high level.

By the above operation, the bank to be selected is switched from the bank A (11) to the bank B (12). Further, the data of the block area BLK1 in the bank B (12) is erased.

The semiconductor memory device according to the present embodiment described above enables its lifetime to be prolonged without performing complicated control.

### <Embodiment 2>

An embodiment 2 will next be described.

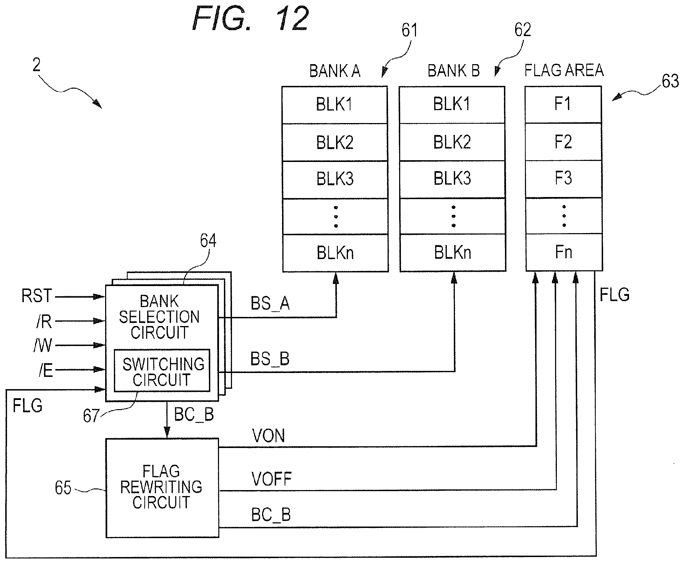

FIG. 12 is a block diagram showing a configuration example of a semiconductor memory device according to the embodiment 2. As illustrated in FIG. 12, the semiconductor memory device 2 according to the present embodiment is equipped with a bank A (61), a bank B (62), a flag area 63, a bank selection circuit 64, and a flag rewriting circuit 65. Incidentally, the bank A (61) and the bank B (62) may be described as a bank A and a bank B respectively.

Since the bank A (61), the bank B (62), and the flag area 63 included in the semiconductor memory device 2 according to the present embodiment are similar to the bank A (11), the bank B (12), and the flag area 13 included in the semiconductor memory device 1 (refer to FIG. 1) described in the embodiment 1, their description will be omitted. In the semiconductor memory device 2 according to the present embodiment, the bank selection circuit 64 and the flag rewriting circuit 65 are different in configuration as compared with the semiconductor memory device 1 described in the embodiment 1.

The bank selection circuit 64 alternately switches the selection of the bank A (61) and the bank B (62) each time an erase command "/E" is issued. The bank selection circuit 64 is equipped with a switching circuit 67. The switching of the bank A (61) and the bank B (62) is controlled by the switching circuit 67. The bank selection circuit 64 sets flag data "FLG" of flag areas F1 through Fn read at power-on to the switching circuit 67 as initial values.

In the configuration example shown in FIG. 12, the bank to be operated out of the bank A (61) and the bank B (62) is selected in block area units. Thus, the bank selection circuit 64 is configured to select either one of block areas BLK1 through BLKn of the bank A (61) and block areas BLK1 through BLKn of the bank B (62), which correspond to each other. Further, the bank selection circuit 64 alternately switches the block areas BLK1 through BLKn to be selected, each time the erase command "/E" is issued.

The bank selection circuit 64 is supplied with a reset signal "RST", a read command "/R", a write command "/W", an erase command "/E", and flag data "FLG". When power is applied to the semiconductor memory device 2, the reset signal "RST" becomes in an active state. When the reset signal "RST" of the active state is supplied, the bank selection circuit 64 sets the flag data "FLG" read from each of the flag areas F1 through Fn to the switching circuit 67 as an initial value. The bank selection circuit 64 selects either one of the bank A (61) and the bank B (62) according to the set initial value.

When selecting the bank, the bank selection circuit 64 outputs bank selection signals BS_A and BS_B in an active state to the banks to be selected respectively. For example, when selecting the bank A (61), the bank selection circuit 64 outputs a bank selection signal BS_A of an active state to the bank A (61) and outputs a bank selection signal BS_B of an inactive state to the bank B (62). Further, when selecting the bank B (62), the bank selection circuit 64 outputs a bank selection signal BS_A of an inactive state to the bank A (61) and outputs a bank selection signal BS_B of an active state to the bank B (62) .

Also, when the read command "/R" is supplied, the bank selection circuit 64 outputs a bank selection signal BS_A or BS_B in an active state to the bank (bank A or B) to execute a read operation. Consequently, the bank to carry out the read operation is selected. The semiconductor memory device 2 performs a read operation on a memory cell at a prescribed address in the selected bank (bank A or B).

Further, when the write command "/W" is supplied, the bank selection circuit 64 outputs a bank selection signal BS_A or BS_B in an active state to the bank (bank A or B) to execute a write operation. Consequently, the bank to execute the write operation is selected. The semiconductor memory device 2 performs a write operation on a memory cell at a prescribed address in the selected bank (bank A or B).

Then, when the erase command "/E" is supplied, the switching circuit 67 of the bank selection circuit 64 switches the bank to be selected. Thereafter, the bank selection circuit 64 outputs a bank selection signal BS_A or BS_B of an active state to the post-switching bank (bank A or B). Thus, the bank to execute an erase operation is selected. The semiconductor memory device 2 erases data of a prescribed block area of the selected bank (bank A or B). The switching circuit 67 holds the post-switching bank as the selected bank until the erase command "/E" is next issued. That is, upon the subsequent read/write operation, the bank selected at this time is used. The use of this bank is continued until the erase command "/E" is next issued.

For example, the bank selection circuit 64 is provided for every block area BLK1 to BLKn. That is, since there are provided n block areas BLK1 through BLKn in the configuration example shown in FIG. 12, n bank selection circuits 64 are provided to correspond to the block areas BLK1 through BLKn respectively.

When power is applied to the semiconductor memory device 2, the flag rewriting circuit 65 supplies a power-on signal "VON" of an active state to the flag areas F1 through Fn. When the power-on signal "VON" of the active state is supplied, the flag areas F1 through Fn output flag data "FLG" stored in the flag areas F1 through Fn to the bank selection circuit 64.

Further, at the power-shutoff of the semiconductor memory device 2, the flag rewriting circuit 65 rewrites the flag data stored in the flag areas F1 through Fn. Specifically, at the power-shutoff of the semiconductor memory device 2, the flag rewriting circuit 65 supplies a power-off signal "VOFF" of an active state and bank selection information BC_B to the respective flag areas F1 through Fn. When the power-off signal "VOFF" of the active state and the bank selection information BC_B are supplied, the respective flag areas F1 through Fn store the bank selection information BC_B in the flag areas F1 through Fn as flag data. Here, the bank selection information BC_B is information supplied from the bank selection circuit 64 and information related to the bank that the switching circuit 67 selects at the power-shutoff.

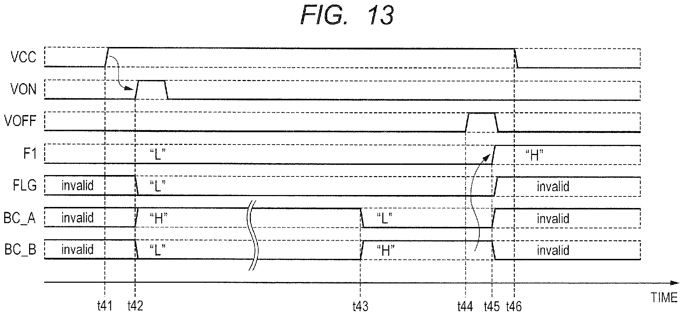

FIG. 13 is a timing chart for describing the operation of the flag rewriting circuit 65. Although the operation of reading and rewriting the flag data in the flag area F1 will be described below as one example, the operation of reading and rewriting the flag data in other flag areas F2 through Fn is also similar.

As shown in FIG. 13, when power is applied to the semiconductor memory device 2, a power supply VCC is brought into an on state (timing t41). When the power is applied to the semiconductor memory device 2, the flag rewriting circuit 65 supplies a power-on signal "VON" of a high level to the flag area F1 (timing t42). Since the low-level flag data is stored in the flag area F1 as shown in FIG. 13, the flag area F1 outputs low-level flag data "FLG" to the bank selection circuit 64 when the power-on signal "VON" of the high level is supplied thereto.

The bank selection circuit 64 sets the flag data "FLG" supplied from the flag area F1 to the switching circuit 67 as an initial value. In this case, since the flag data "FLG" is at the low level, the bank selection circuit 64 sets a signal "BC_A" to a high level and sets a signal "BC_B" to a low level. Here, the signals "BC_A" and "BC_B" respectively correspond to the bank selection signals BS_A and BS_B. Incidentally, the detailed configuration of the bank selection circuit 64 will be described later.

Subsequently, the switching circuit 67 of the bank selection circuit 64 alternately switches the selection of the bank A (61) and the bank B (62) each time the erase command "/E" is issued. For example, at a timing t43, the signal "BC_A" is at the low level, and the signal "BC_B" is at the high level. In this case, the bank B (62) is selected.

Thereafter, the power-off signal "VOFF" is brought to a high level at a timing t44 when the power shutoff of the semiconductor memory device 2 is made. At this time, the flag rewriting circuit 65 supplies the signal "BC_B" to the flag area F1 as the bank selection information BC_B together with the high-level power-off signal "VOFF". When the flag area F1 is supplied with the power-off signal "VOFF" of the active state and the bank selection information BC_B, the bank selection information BC_B is stored in the flag area F1 as flag data at a timing t45. That is, in this case, high-level flag data is written in the flag area F1. After the flag data is written in the flag area Fl, the power supply VCC of the semiconductor memory device 2 becomes in an off state (timing t46).

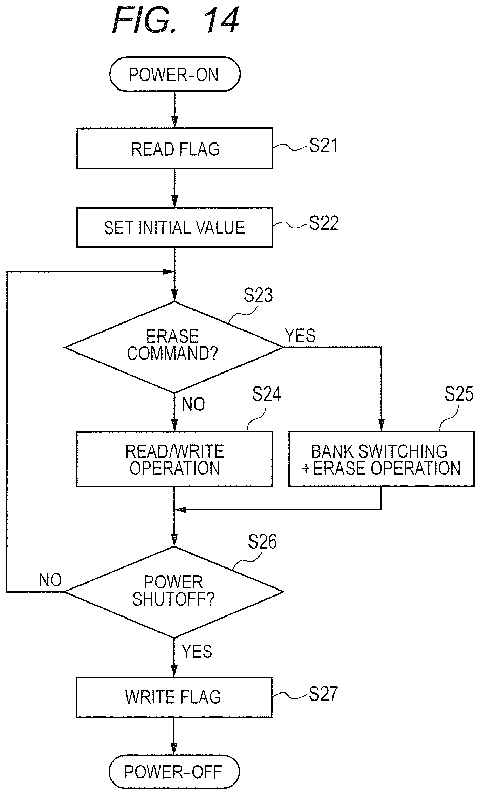

The operation of the semiconductor memory device 2 according to the present embodiment will next be described using a flowchart shown in FIG. 14. Incidentally, although the read/write operation of data in the block area BLK1 and its erase operation will be described below as one example, the read/write operation of data in each of other block areas BLK2 through BLKn and its erase operation are also similar.

When the power is applied to the semiconductor memory device 2 shown in FIG. 12, the flag rewriting circuit 65 supplies a power-on signal "VON" of an active state to the flag area F1. When the power-on signal "VON" of the active state is supplied, the flag area F1 outputs flag data "FLG" stored in the flag area F1 to the bank selection circuit 64 (Step S21 of FIG. 14).

Further, when the power is applied to the semiconductor memory device 2, the reset signal "RST" supplied to the bank selection circuit 64 becomes in an active state. When the reset signal "RST" of the active state is supplied, the bank selection circuit 64 sets the flag data "FLG" read from the flag area F1 to the switching circuit 67 as an initial value (Step S22).

Thereafter, the bank selection circuit 64 determines whether the command supplied to the bank selection circuit 64 is the erase command "/E" (Step S23). When the command supplied to the bank selection circuit 64 is determined not to be the erase command "/E" (Step S23: No), i.e., when the command supplied to the bank selection circuit 64 is the read command "/R" or write command "/W", the bank selection circuit 64 executes a read/write operation (Step S24). That is, the bank selection circuit 64 outputs a bank selection signal BS_A or BS_B of an active state to the bank (bank A or B) to perform the read/write operation. Thus, the bank to perform the read/write operation is selected. The semiconductor memory device 2 performs a read/write operation on the corresponding memory cell of the block area BLK1 in the selected bank (bank A or B) .

On the other hand, when the command supplied to the bank selection circuit 64 is the erase command "/E" (Step S23: Yes), the bank selection circuit 64 executes a bank switching operation and an erase operation (Step S25). That is, when the erase command "/E" is supplied, the switching circuit 67 of the bank selection circuit 64 switches the bank to be selected. Thereafter, the bank selection circuit 64 outputs a bank selection signal BS_A or BS_B of an active state to the post-switching bank (bank A or B). Thus, the bank to execute the erase operation is selected. The semiconductor memory device 2 erases data of the block area BLK1 in the selected bank (bank A or B). The switching circuit 67 holds the selected bank as a selected bank until the erase command "/E" is next issued. That is, the bank selected at this time is used in the subsequent read/write operation. The use of this bank is continued until the erase command "/E" is next issued.

Next, the flag rewriting circuit 65 determines whether the power supply of the semiconductor memory device 2 is shut off (Step S26). When the power supply of the semiconductor memory device 2 is not shut off (Step S26: No), the semiconductor memory device 2 repeats the operation of Steps S23 through S26. At this time, the bank selection circuit 64 alternately switches the selection of the bank A (61) and the bank B (62) each time the erase command "/E" is issued.

On the other hand, when the power supply of the semiconductor memory device 2 is shut off (Step S26: Yes), the flag rewriting circuit 65 executes a flag read operation (Step S27). That is, at the time of the power shutoff of the semiconductor memory device 2, the flag rewriting circuit 65 supplies a power-off signal "VOFF" of an active state and bank selection information BC_B to the flag area F1. When the flag area F1 is supplied with the power-off signal "VOFF" of the active state and the bank selection information BC_B, the bank selection information BC_B is stored in the flag area F1 as flag data.

Here, the bank selection information BC_B is information supplied from the bank selection circuit 64 and information related to the bank that the switching circuit 67 selects at the power-shutoff. Thus, when the power supply of the semiconductor memory device 2 is turned on next time, the bank selection circuit 64 is capable of selecting the bank which has been selected at the previous power shutoff.

As described above, even in the semiconductor memory device 2 according to the present embodiment, the bank selection circuit 64 alternately switches the bank to be selected, each time the erase command is issued. It is therefore possible to prolong the lifetime of the semiconductor memory device 2 without performing complicated control.

Incidentally, the above-described example has shown the case where the power-off sequence is started at the normal operation, and the power-off signal "VOFF" becomes high in level (refer to the timing t44 in FIG. 13). However, the present embodiment may be configured in such a manner that the power-off signal "VOFF" is brought to the high level at the time of abnormal operations during which a power supply is suddenly turned off, such as an instantaneous power failure, etc. Likewise, even in this case, flag data is written in the flag area F1 after the power-off signal "VOFF" is brought to the high level (refer to the timing t45 in FIG. 13 and Step S27 in FIG. 14).

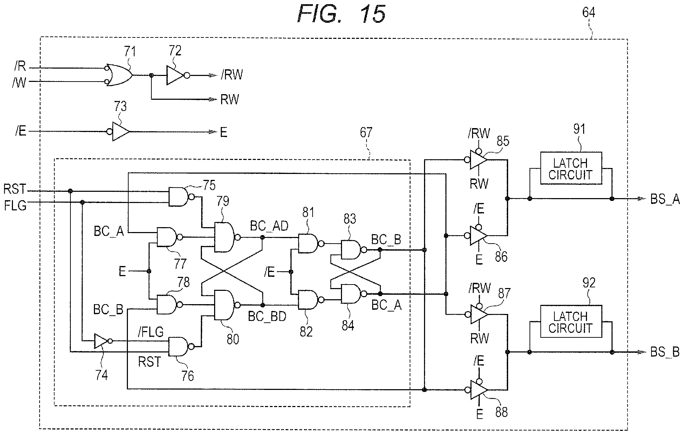

A specific circuit configuration of the bank selection circuit 64 will next be described using FIG. 15. Incidentally, the bank selection circuit 64 shown in FIG. 15 is one example. In the present embodiment, any circuit may be used so long as there is provided a bank selection circuit 64 capable of performing the above-described operations.

The bank selection circuit 64 shown in FIG. 15 is equipped with logic circuits 71 through 88 and latch circuits 91 and 92. The logic circuit 71 is an OR circuit equipped with inverse inputs. The logic circuit 71 has one input supplied with a read command "/R", and the other input supplied with a write command "/W". The logic circuit 71 outputs the OR of an inverted signal of the read command "/R" and an inverted signal of the write command "/W" as a signal "RW". The logic circuit 72 is an inverter circuit and outputs a signal "/RW" obtained by inverting the signal "RW" output from the logic circuit 71. The logic circuit 73 is a buffer circuit which is equipped with an inverse input and outputs a signal "E" obtained by inverting an erase command "/E" supplied thereto.

The switching circuit 67 is configured using the logic circuits 74 through 84. The logic circuit 74 is an inverter circuit (hereinafter also described as an inverter circuit 74) . The logic circuits 75 through 84 are NAND circuits (hereinafter also described as NAND circuits 75 through 84).

The NAND circuit 75 is inputted with a reset signal "RST" and flag data "FLG" and outputs NAND of these. The NAND circuit 76 is inputted with a signal obtained by inverting the flag data "FLG" by the inverter circuit 74 and the reset signal "RST", and outputs NAND of these. The NAND circuit 77 is inputted with an output signal "BC_A" of the NAND circuit 84 and the signal "E" and outputs NAND of these. The NAND circuit 78 is inputted with an output signal "BC_B" of the NAND circuit 83 and the signal "E" and outputs NAND of these. The NAND circuit 79 is inputted with the output signals of the NAND circuits 75, 77, and 80 and outputs NAND of these. The NAND circuit 80 is inputted with the output signals of the NAND circuits 76, 78, and 79 and outputs NAND of these.

The NAND circuit 81 is inputted with the output signal "BC_AD" of the NAND circuit 79 and the erase command "/E" and outputs NAND of these. The NAND circuit 82 is inputted with the output signal "BC_BD" of the NAND circuit 80 and the erase command "/E" and outputs NAND of these. The NAND circuit 83 is inputted with the output signal of the NAND circuit 81 and the output signal "BC_A" of the NAND circuit 84 and outputs NAND of these. The NAND circuit 84 is inputted with the output signal of the NAND circuit 82 and the output signal "BC_B" of the NAND circuit 83 and outputs NAND of these.

In the switching circuit 67 shown in FIG. 15, the signal "BC_AD" and the signal "BC_BD" are inverted with a timing at which the erase command "/E" falls and the signal "E" rises. Further, the signal "BC_A" and the signal "BC_B" are inverted with a timing at which the erase command "/E" rises and the signal "E" falls. The detailed operation of the switching circuit 67 will be described later.

The logic circuit 85 is a buffer circuit equipped with an inverse input and outputs a signal obtained by inverting the signal BC_B as a bank selection signal BS_A according to the signal "/RW" and the signal "RW". The logic circuit 86 is a buffer circuit equipped with an inverse input and outputs a signal obtained by inverting the signal BC_A as a bank selection signal BS_A according to the signal "/E" and the signal "E". The logic circuit 87 is a buffer circuit equipped with an inverse input and outputs a signal obtained by inverting the signal BC_A as a bank selection signal BS_B according to the signal "/RW" and the signal "RW". The logic circuit 88 is a buffer circuit equipped with an inverse input and outputs a signal obtained by inverting the signal BC_B as a bank selection signal BS_B according to the signal "/E" and the signal "E".

The latch circuit 91 is a circuit which latches the bank selection signal BS_A output from each of the logic circuits 85 and 86. The latch circuit 92 is a circuit which latches the bank selection signal BS_B output from each of the logic circuits 87 and 88.

In the bank selection circuit 64 shown in FIG. 15, when either one of the read command "/R" and the write command "/W" is at a low level (active state), a signal "RW" of a high level (active state) is output from the logic circuit 71. At this time, the logic circuit 72 outputs a signal "/RW" of a low level (active state). Further, when the erase command "/E" is at a low level (active state), a signal "E" of a high level (active state) is output from the logic circuit 73.

When the signal "/RW" and the signal "RW" are respectively in an active state, the logic circuit 85 outputs a signal obtained by inverting the logic level of the signal "BC_B" as a bank selection signal BS_A. On the other hand, when the signal "/RW" and the signal "RW" are respectively in the active state, the logic circuit 87 outputs a signal obtained by inverting the logic level of the signal "BC_A" as a bank selection signal BS_B.

When the erase command "/E" and the signal "E" are respectively in an active state, the logic circuit 86 outputs a signal obtained by inverting the logic level of the signal "BC_A" as a bank selection signal BS_A. On the other hand, when the erase command "/E" and the signal "E" are respectively in the active state, the logic circuit 88 outputs a signal obtained by inverting the logic level of the signal "BC_B as a bank selection signal BS_B.

Here, when one of the signal "BC_A" and the signal "BC_B" is low in level, the other thereof becomes a high level. Therefore, when one of the bank selection signal BS_A and the bank selection signal BS_B is low in level, the other thereof becomes a high level. Thus, either one of the banks A and B is selected.

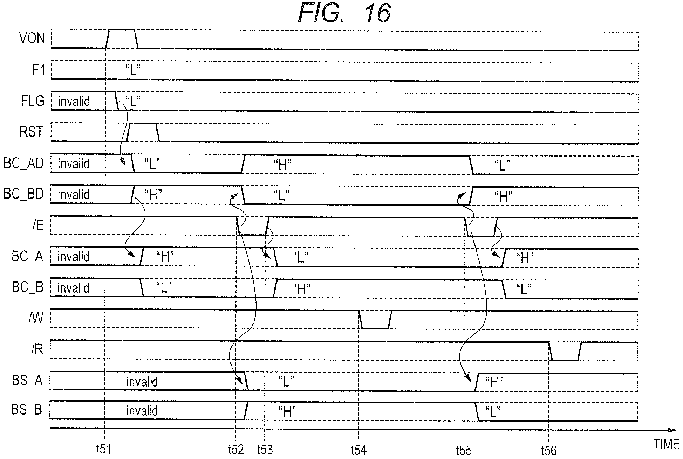

The operation of the bank selection circuit 64 shown in FIG. 15 will next be described using a timing chart shown in FIG. 16. Incidentally, although the operation of a bank selection circuit corresponding to a block area BLK1 will be described below as one example, the operation of a bank selection circuit corresponding to each of other block areas BLK2 through BLKn is also similar.

When power is applied to the semiconductor memory device 2, a power-on signal "VON" of a high level is supplied to the flag area F1 (timing t51). Since flag data of a low level is stored in the flag area F1 as shown in FIG. 16, the flag area F1 outputs flag data "FLG" of a low level to the bank selection circuit 64 when the power-on signal "VON" of the high level is supplied thereto. Further, when power is applied to the semiconductor memory device 2, a reset signal "RST" becomes a high level.

Thus, the NAND circuit 75 of the switching circuit 67 shown in FIG. 15 is supplied with the reset signal "RST" of the high level and the flag data "FLG" of the low level. Thus, the NAND circuit 75 outputs a high level signal. On the other hand, the NAND circuit 76 is supplied with a signal (high level signal) obtained by inverting the flag data "FLG" of the low level by means of the inverter circuit 74 and the reset signal "RST" of the high level. Thus, the NAND circuit 76 outputs a low level signal.

Also, since the erase command "/E" is at the high level, the signal "E" becomes a low level. Thus, the NAND circuits 77 and 78 supplied with the signal "E" both outputs a high level signal. Here, the NAND circuits 79 and 80 are respectively a three-input NAND circuit and respectively output a low level signal when at least two signals of three inputs are at a high level. Thus, since the NAND circuit 79 is supplied with the high level signal from the NAND circuit 75 and the high level signal from the NAND circuit 77, the NAND circuit 79 outputs a low level signal "BC_AD". On the other hand, since the NAND circuit 80 is supplied with the low level signal from the NAND circuit 76, the high level signal from the NAND circuit 78, and the low level signal from the NAND circuit 79 respectively, the NAND circuit 80 outputs a high level signal "BC_BD".

Further, the NAND circuit 81 is supplied with the low level signal from the NAND circuit 79 and supplied with the high-level erase command "/E". Thus, the NAND circuit 81 outputs a high level signal. On the other hand, the NAND circuit 82 is supplied with the high level signal from the NAND circuit 80 and supplied with the high-level erase command "/E". Thus, the NAND circuit 82 outputs a low level signal.

Besides, since the NAND circuit 84 is supplied with the low level signal from the NAND circuit 82, the NAND circuit 84 outputs a high level signal "BC_A". On the other hand, since the NAND circuit 83 is supplied with the high level signal from the NAND circuit 81 and supplied with the high level signal "BC_A" from the NAND circuit 84, the NAND circuit 83 outputs a low level signal "BC_B".

Thereafter, when the erase command "/E" becomes in an active state (low level) at a timing t52 shown in FIG. 16, the NAND circuits 77 and 78 of the switching circuit 67 shown in FIG. 15 are supplied with a high level signal "E".

At this time, since the NAND circuit 77 is supplied with the high level signal "BC_A" and the high level signal "E", the NAND circuit 77 outputs a low level signal. Further, since the NAND circuit 78 is supplied with the low level signal "BC_B" and the high level signal "E", the NAND circuit 78 outputs a high level signal.

Thus, since the NAND circuit 79 is supplied with the low level signal from the NAND circuit 77, the NAND circuit 79 outputs a high level signal "BC_AD". Further, since the NAND circuit 80 is supplied with the high level signal from the NAND circuit 78 and the high level signal from the NAND circuit 79, the NAND circuit 80 outputs a low level signal "BC_BD".

Thereafter, when the erase command "/E" rises at a timing t53 as shown in FIG. 16, the NAND circuits 81 and 82 of the switching circuit 67 shown in FIG. 15 are respectively supplied with the high-level erase command "/E". At this time, the NAND circuit 81 is supplied with the high level signal from the NAND circuit 79 and supplied with the high-level erase command "/E". Thus, the NAND circuit 81 outputs a low level signal. On the other hand, the NAND circuit 82 is supplied with the low level signal from the NAND circuit 80 and supplied with the high-level erase command "/E". Thus, the NAND circuit 82 outputs a high level signal.

Also, since the NAND circuit 83 is supplied with the low level signal from the NAND circuit 81, the NAND circuit 83 outputs a high level signal "BC_B". On the other hand, since the NAND circuit 84 is supplied with the high level signal from the NAND circuit 82 and supplied with the high level signal "BC_B" from the NAND circuit 83, the NAND circuit 84 outputs a low level signal "BC_A".

Further, when the erase command "/E" becomes in the active state (low level) at the timing t52, the logic circuit 86 outputs a signal obtained by inverting the logic level of the signal "BC_A" as a bank selection signal BS_A. On the other hand, the logic circuit 88 outputs a signal obtained by inverting the logic level of the signal "BC_B" as a bank selection signal BS_B. Thus, in this case, a low level signal is output as the bank selection signal BS_A, and a high level signal is output as the bank selection signal BS_B.

Thereafter, when the write command "/W" becomes in an active state at a timing t54, the signal "/RW" and the signal "RW" are respectively brought into an active state. Thus, the logic circuit 85 outputs a signal obtained by inverting the logic level of the signal "BC_B" as a bank selection signal BS_A. On the other hand, the logic circuit 87 outputs a signal obtained by inverting the logic level of the signal "BC_A" as a bank selection signal BS_B. That is, in this case, a low level signal is output as the bank selection signal BS_A, and a high level signal is output as the bank selection signal BS_B. Thus, the bank B is selected. The semiconductor memory device 2 performs a write operation on a memory cell at a prescribed address in the selected bank B.

Incidentally, since the operation when the erase command "/E" is brought into an active state (low level) at a timing t55, and the operation when the read command "/R" is brought into an active state at a timing t56 are basically similar to the above-described case, their dual description will be omitted.

The semiconductor memory device according to the present embodiment described above enables its lifetime to be prolonged without performing complicated control. In the semiconductor memory device 2 according to the present embodiment in particular, the flag data is set to the switching circuit 67 at power-on, and thereafter the switching of the bank is performed by the switching circuit 67. Thus, since it is not necessary to read the flag data from the flag areas F1 through Fn and rewrite the same each time and as in the semiconductor memory device 1 described in the embodiment 1, the operation of the semiconductor memory device 2 can be made fast.

Incidentally, although the above embodiments 1 and 2 have described the semiconductor memory devices each equipped with the two banks, the number of banks included in the semiconductor memory device may be three or more. For example, when there are provided three banks, the three banks may be configured to be switched in order each time the erase command is issued. Further, for example, when there are provided four banks, two sets of bank groups in total are formed with two banks as one set, and the two banks may be switched in order in the banks groups respectively each time the erase command is issued.

Also, the semiconductor memory devices 1 and 2 according to the above embodiments 1 and 2 may further respectively be provided with a mode switching circuit which switches the operation modes of the semiconductor memory devices 1 and 2. For example, when configuring the semiconductor memory devices 1 and 2, they may be configured so as to be capable of setting a first mode and a second mode as the operation modes and switching the first and second modes by using the mode switching circuit.

Here, the first mode is a mode of selecting either one of the banks A and B by using the bank selection circuit 14 or 64 (refer to FIG. 1 or 12), and enabling data to be stored in either one of the banks A and B. That is, it is a mode of enabling the operation described in each of the above-described embodiments 1 and 2 to be performed. Since the bank A and the bank B are alternately operated in the first mode, the number of times of rewriting as the whole semiconductor memory device can substantially be doubled, and hence the lifetime of the semiconductor memory device can be prolonged.

On the other hand, the second mode is a mode of enabling data to be stored in both of the banks A and B. Both of the banks A and B are in a state of being operable independently together. That is, in the second mode, it is possible to store different data in different addresses of the banks A and B respectively. Although the lifetime of the semiconductor memory device is reduced to half in the second mode as compared with the case in the first mode, the storage capacity of the semiconductor memory device can be doubled as compared with the first mode because both of the banks A and B can be used simultaneously as storage areas.

For example, the semiconductor memory device is capable of switching the first mode and the second mode according to the user's desire. That is, when priority is given to the lifetime (number of times of rewriting) of the semiconductor memory device, a user may set the first mode as the operation mode of the semiconductor memory device. On the other hand, when priority is given to the storage capacity of the semiconductor memory device, the user may set the second mode as the operation mode of the semiconductor memory device.

Although the invention made above by the present inventors has been described specifically on the basis of the preferred embodiments, the present invention is not limited to the embodiments referred to above. It is needless to say that various changes can be made thereto within the scope not departing from the gist thereof.

## Claims

1. A semiconductor memory device comprising:
first and second banks operable complementarily to each other; and
a bank selection circuit which selects either one of the first and second banks,
wherein the bank selection circuit alternately switches the bank to be selected, each time an erase command to instruct erasing of data in either one of the first and second banks is issued.

2. The semiconductor memory device according to claim 1,
wherein the first and second banks are respectively equipped with a plurality of block areas corresponding to erase units of data,
wherein the block areas of the first bank and the block areas of the second bank are provided to correspond to each other, and
wherein the bank selection circuit is configured to select either one of the block area of the first bank and the block area of the second bank, which correspond to each other, and alternately switches the block area to be selected, each time the erase command is issued.

3. The semiconductor memory device according to claim 2,
wherein each of the block areas of the first bank comprises a plurality of memory cells,
wherein each of the block areas of the second bank comprises a plurality of memory cells, and
wherein the memory cells of the first bank and the memory cells of the second bank are configured to correspond to each other, and
wherein when accessing from the outside, the memory cells of the first bank and the memory cells of the second bank are configured to be accessible using the same address.

4. The semiconductor memory device according to claim 1, further comprising a flag area storing therein flag data indicative of the bank to be selected,
wherein the bank selection circuit selects either one of the first and second banks according to the flag data stored in the flag area.

5. The semiconductor memory device according to claim 4, further comprising a flag rewriting circuit which rewrites the flag data stored in the flag area,
wherein the flag rewriting circuit alternately rewrites flag data indicative of the first bank and flag data indicative of the second bank each time the erase command is issued.

6. The semiconductor memory device according to claim 1, further comprising a flag area storing therein flag data indicative of the bank to be selected,
wherein the bank selection circuit is equipped with a switching circuit which alternately switches the selection of the first and second banks each time the erase command is issued, and
wherein the bank selection circuit sets the flag data stored in the flag area to the switching circuit as an initial value.

7. The semiconductor memory device according to claim 6, wherein the flag data is read from the flag area at power-on and set to the switching circuit as the initial value.

8. The semiconductor memory device according to claim 6, further comprising a flag rewriting circuit which rewrites the flag data stored in the flag area,
wherein at power-shutoff, the flag rewriting circuit stores bank selection information included in the switching circuit in the flag area as the flag data.

9. The semiconductor memory device according to claim 1, further comprising a mode switching circuit which switches an operation mode of the semiconductor memory device,
wherein the mode switching circuit is configured to be switchable between a first mode of selecting either one of the first and second banks by using the bank selection circuit and enabling data to be stored in either one of the first and second banks, and a second mode of accessing both the first and second banks by using different addresses respectively and enabling data to be stored therein.

10. A control method for a semiconductor memory device including first and second banks operable complementarily to each other, comprising the step of:
alternately switching the bank to be selected, each time an erase command to instruct erasing of data in either one of the first and second banks is issued.
